# EUROPEAN PATENT APPLICATION

(11) **EP 4 794 449 A1**
(43) Date of publication of application: **19.08.2026**
(21) Application number: 26158735.6
(22) Date of filing: 16.02.2026
(51) Int. Cl.: H05B 3/56

(54) **INTEGRATED BUSBAR FRAME FOR CERAMIC POSITIVE TEMPERATURE COEFFICIENT HEATERS**

(30) Priority: 14.02.2025 US 202563758450 P
(71) Applicant: Chemelex Europe GmbH, 8200 Schaffhausen (CH)
(72) Inventor: Wang, Jimmy, Hillsborough, 94010 (US); Raut, Prasad, San Jose, 95131 (US); Kiss, Linda D.B., San Mateo, 94403 (US); Yu, Dong, Fremont, 94539 (US); Jarvis, William Edward, Millbrae, 94030 (US)
(74) Representative: Barker Brettell LLP

(57) **Abstract**

A self-regulating heating cable (10) and production methods are provided. The self-regulating heating cable includes a conductive bus-frame (12) and a ceramic positive temperature coefficient (PTC) chip (14). The conductive bus-frame includes a first frame element (12A) with a first stem (24) and a first chip tab (26) integral with and extending outward from the first stem, and a second frame element (12B) parallel to the first frame element and including a second stem (24) and a second chip tab (26) integral with and extending outward from the second stem. The PTC chip is disposed between and retained by the first chip tab and the second chip tab to create an electrical pathway from the first frame element through the first chip tab, the PTC chip, and the second chip tab to the second frame element.

## Description

### CROSS-REFERENCE TO RELATED APPLICATIONS

This application claims priority under 35 U.S.C. § 119 to United States Provisional Patent Application No. 63/758,450 filed on February 14, 2025, the entire contents of which are incorporated herein by reference.

### BACKGROUND

Heater cables, such as self-regulating heater cables, tracing tapes, and other types, are cables configured to provide heat in applications requiring such heat. Heater cables offer the benefit of being field-configurable. For example, heater cables may be applied or installed as needed without the requirement that application-specific heating assemblies be custom-designed and manufactured, though heater cables may be designed for application-specific uses in some instances.

In some approaches, a heater cable operates by use of two or more bus wires having a high conductance coefficient (i.e., low resistance). The bus wires are coupled to differing voltage supply levels to create a voltage potential between the bus wires. A positive temperature coefficient (PTC) material can be situated between the bus wires and current is allowed to flow through the PTC material, thereby generating heat by resistive conversion of electrical energy into thermal energy. As the temperature of the PTC material increases, so does its resistance, thereby reducing the current therethrough and, therefore, the heat generated via resistive heating. The heater cable is thus self-regulating in terms of the amount of thermal energy (i.e., heat) output by the cable.

### SUMMARY

Some examples provide a self-regulating heating cable including a conductive bus-frame and a ceramic positive temperature coefficient (PTC) chip. The conductive bus-frame includes a first frame element with a first stem and a first chip tab integral with and extending outward from the first stem, and a second frame element parallel to the first frame element and including a second stem and a second chip tab integral with and extending outward from the second stem. The PTC chip is disposed between and retained by the first chip tab and the second chip tab to create an electrical pathway from the first frame element through the first chip tab, the PTC chip, and the second chip tab to the second frame element.

Some examples provide a method of producing a self-regulating heating cable. The method includes aligning a first conductive frame element parallel to a second conductive frame element. The method also includes placing a ceramic positive temperature coefficient (PTC) chip between a first chip tab of the first frame element and a second chip tab of the second frame element, such that the first chip tab extends over a top of the PTC chip and the second chip tab extends over a bottom of the PTC chip, and the PTC chip is electrically connected to the first conductive frame element via the first chip tab and to the second conductive frame element via the second chip tab.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. Features described in connection with the self-regulating heating cable or any feature(s) or component(s) described may have corresponding features definable and/or combinable with respect to a system or method or vice versa, and these embodiments are specifically envisaged.

### DESCRIPTION OF THE DRAWINGS

FIG. 1 is an isometric cutaway view a self-regulating heater cable according to some embodiments.
FIG. 2 is an enlarged view of the self-regulating heater cable of FIG. 1, taken at section II of FIG. 1.
FIG. 3 is a cross-sectional view of the self-regulating heater cable of FIG. 1, taken along line III-III of FIG. 1.
FIG. 4 is a flow chart of a method for a manufacturing self-regulating heater cable according to an example implementation.

### DETAILED DESCRIPTION

Before any examples are explained in detail, it is to be understood that the disclosure is not limited in its application to the details of construction and the arrangement of components set forth in the following description or illustrated in the following drawings. The disclosure is capable of other examples and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The following discussion is presented to enable a person skilled in the art to make and use examples of the disclosure. Various modifications to the illustrated examples will be readily apparent to those skilled in the art, and the generic principles herein can be applied to other examples and applications without departing from the scope of the disclosure. Thus, examples of the disclosure are not intended to be limited to examples shown, but are to be accorded the widest scope consistent with the principles and features disclosed herein. The following detailed description is to be read with reference to the figures, in which like elements in different figures have like reference numerals. The figures, which are not necessarily to scale, depict selected examples and are not intended to limit the scope of the disclosure. Skilled artisans will recognize the examples provided herein have many useful alternatives and fall within the scope of the disclosure.

Heater cables, such as self-regulating heater cables, may be used in a variety of applications, including freeze protection, temperature maintenance, and process heating. In some applications, heater cables may be used for industrial purposes such as pipe tracing, tank heating, and roof or gutter de-icing. Self-regulating heater cables may operate by use of two or more bus wires having a high conductance coefficient, with a positive temperature coefficient (PTC) material situated between the bus wires to generate heat by resistive conversion of electrical energy into thermal energy. Conventional heater cables generally embed or retain the PTC material between the bus wires using perfluoroalkyl or polyfluoroalkyl materials (PFAs). For high temperature self-regulating cables operating above 150 degrees Celsius, alternatives to fluoropolymer-based cables have been challenging to develop, as no drop-in technical alternatives to fluoropolymers currently exist in the plastics space for such high temperature applications.

The disclosed technology of some examples, on the other hand, provides a self-regulating heater cable that is free of PFAs through the use of ceramic PTC chips suspended between conductive frame elements, thereby providing efficient and reliable thermal output without the use of PFAs or other polymer-based materials. The ceramic PTC chips, combined with inorganic jacket materials as described below, may allow for higher temperature capability compared to polymeric cables, with maximum continuous exposure levels of 205 degrees Celsius or above and intermittent exposure temperatures of 260 degrees Celsius or above.

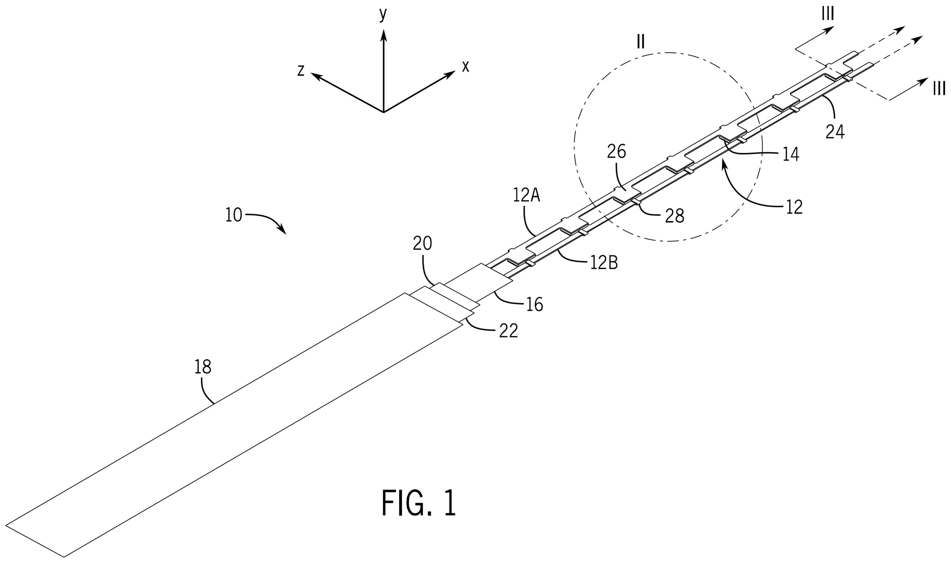

Accordingly, FIG. 1 illustrates a self-regulating heating cable 10 according to some embodiments. As shown in FIG. 1, the cable 10 can include a conductive bus-frame 12, a plurality of positive temperature coefficient (PTC) chips 14, a primary jacket 16, a final jacket 18, and an optional barrier layer 20 and/or a ground plane 22 disposed between the primary jacket 16 and the final jacket 18.

In some examples, the bus-frame 12 can include two parallel frame elements 12A, 12B, which can each be made of a conductive material (e.g., electrically conducting material), such as a metal (e.g., copper, spring steel, aluminum, nickel, tin-plated copper, brass, bronze, or other conducting metal or metal alloy), or other conductive material. The frame elements 12A, 12B can provide a conductive path for electrical current and, thus, may collectively be referred to as a "busbar-frame" or "bus-frame." Furthermore, in some examples, each of the frame elements 12A, 12B can be a solid metal conductor, or can include braids or laminated copper. The frame elements 12A, 12B can be substantially flat or can have other geometries. Generally, the frame elements 12A, 12B can be parallel to each other and spaced apart a distance approximately equivalent to a width of the PTC chips 14. Furthermore, the frame elements 12A, 12B can be coupled to or otherwise secure the PTC chips 14 between the frame elements 12A, 12B. The frame elements 12A, 12B, by providing a parallel conductor construction, can be manufactured in long lengths and can allow the cable 10 to be cut to length for a particular application. For example, in some applications, long lengths of the bus-frame 12 can be spooled into a reel, then paid out in a continuous assembly process.

In some examples, the bus-frame 12 may include more than two frame elements. For example, the bus-frame 12 may include three or more frame elements arranged in parallel, with PTC chips 14 disposed between adjacent pairs of frame elements to create multiple electrical pathways. Additionally, in some examples, the frame elements 12A, 12B may be arranged in configurations other than parallel, such as converging, diverging, or serpentine configurations along the length of the cable 10.

In one particular example, the first frame element 12A and/or the second frame element 12B may be made of flat copper. Flat copper frame elements 12A, 12B may provide a balance of electrical conductivity, mechanical formability, and cost-effectiveness for the bus-frame 12. The flat configuration of the copper frame elements may facilitate the stamping, bending, or crimping operations used to form chip tabs 26 and chip stops 28 as further described below, while also providing a low-resistance electrical pathway for current flow through the bus-frame 12.

Generally, the PTC chips 14 can be sized to fit between and contact the frame elements 12A, 12B, thus providing a conductive path for the electrical current between the frame elements 12A, 12B. In some examples, the PTC chips 14 can be made of a ceramic material. As shown in FIG. 1, the PTC chips 14 can be spaced apart along a length of the heating cable 10, though, in some examples, this spacing may be closer together or further apart than what is illustrated. For example, the spacing between the PTC chips 14 can be determined by a desired power output (defined as Watts per foot or Watts per meter) of the heating cable 10. Additionally, in some examples, the spacing between the PTC chips 14 can be uniform or irregular.

Additionally, the bus-frame 12 and the PTC chips 14 can be surrounded by the primary jacket 16, which can be an electrically insulating compound. On top of the primary jacket 16, the optional barrier layer 20 can act as a barrier for the interior components (e.g., protecting them from water and/or chemicals). The barrier layer 20 can be a metallic foil, such as aluminum foil. The ground plane 22 (e.g., a tinned-copper or other metallic braid or wrap) can then surround the aluminum foil barrier layer 20 or the primary jacket 16 and acts as a ground path. On top of the ground plane 22 (or primary jacket 16), the final jacket 18 acts as a mechanical protection layer.

In some examples, the primary jacket 16 and the final jacket 18 may be made of an inorganic material. For example, the primary jacket 16 may be made of glass tape, mica, silica, glass yarn, ceramic tape, ceramic fiber, mineral wool, metallic tubing, or other inorganic materials. Additionally, the final jacket 18 may be made of a metallic tubing, such as smooth or corrugated metallic tubing in some examples, or may include stainless steel, or other high-temperature metal alloys. The inorganic materials of the primary and final jackets 16, 18 may aid the distribution of thermal energy along lengths of the self-regulating heating cable 10, as well as to the ambient environment. The inorganic materials of the primary and final jackets 16, 18 may, thus, consequently aid the reduction of cold spots along the heating cable 10. Furthermore, the inorganic materials of the primary and final jackets 16, 18, as well as the ceramic (i.e., non-polymer) PTC chips 14, may allow for the heating cable 10 to be operable at higher temperatures compared to heating cables with polymeric jackets or internal components. However, it is appreciated that the primary jacket 16 and the final jacket 18 may also include polymers or some other organic material in some examples.

In some examples, the primary jacket 16 may be applied by methods other than wrapping, such as extrusion, molding, dipping, spraying, or deposition. The primary jacket 16 may comprise multiple layers of the same or different materials. In some examples, the primary jacket 16 may include a combination of organic and inorganic materials, such as a silicone-based material with inorganic fillers. The primary jacket 16 may also include reinforcing elements, such as fibers, meshes, or braids, embedded within the jacket material.

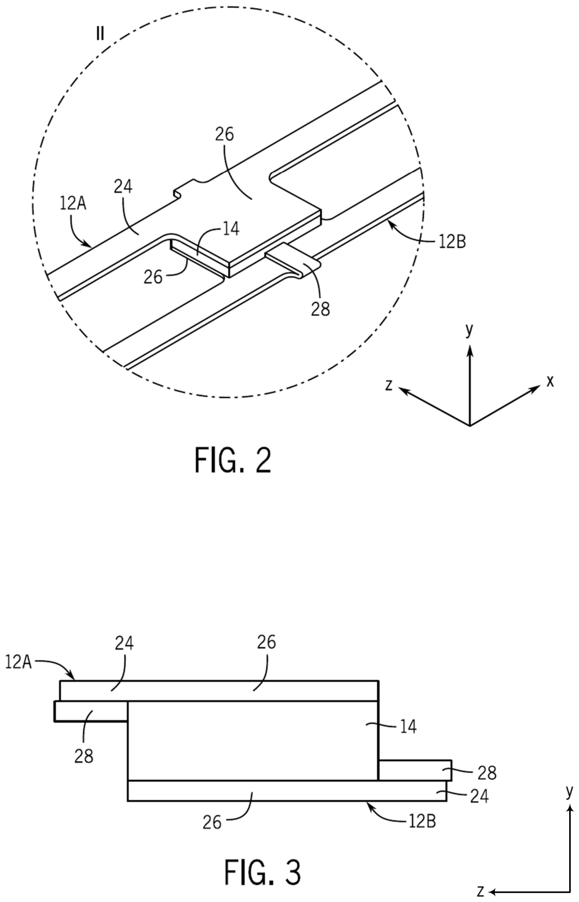

Referring now to FIGS. 1-3, a heat generating core of the self-regulating heating cable 10 can generally include the PTC chips 14. The bus-frame 12 can provide both a structure to hold the PTC chips 14 in a spaced-apart manner, as well as an electrical bus for electrically connecting PTC chips 14. As illustrated in FIG. 2, each frame element 12A, 12B can include a stem 24 that extends a length of the frame element 12A, 12B (e.g., along an X-axis). The stem 24 may have various cross-sectional shapes, including rectangular, square, circular, or other geometries, and may be solid or hollow. A plurality of chip tabs 26 extend axially outward from each stem 24 in a first direction (e.g., along a Z-axis, or width of the bus-frame 12), and a plurality of chip stops 28 extend axially outward from each stem 24 in a second direction, perpendicular to the first direction (e.g., along a Y-axis, or height of the bus-frame 12). The chip tabs 26 and the chip stops 28 can collectively act as holding mechanisms that hold the PTC chips 14 in place between the frame elements 12A, 12B and prevent movement from side-to-side (e.g., at least along the Y- and Z-axes).

In some examples, the chip tabs 26 and/or the chip stops 28 of each of the frame elements 12A, 12B may be formed through stamping, bending, crimping, machining, or other mechanical manipulations. For example, the PTC chips 14 may be indexed in the bus-frame 12 by mechanical features that are bent from or machined in the bus-frame 12. Furthermore, in some examples, the chip tabs 26 and/or the chip stops 28 may be integrally formed with the stems 24 or coupled to the stems 24. In some applications, a high temperature conductive adhesive may be used to affix the PTC chips 14 to the bus-frame 12, either alone or in combination with the mechanical features described above.

In some examples, the chip tabs 26 may extend from the stem 24 at various angles relative to the stem 24, including perpendicular, oblique, or curved orientations. The chip tabs 26 may be planar or may include contoured surfaces configured to conform to the shape of the PTC chips 14. Additionally, in some examples, the chip tabs 26 may include apertures, slots, or textured surfaces to enhance mechanical retention or electrical contact with the PTC chips 14. In some examples, the chip tabs 26 may wrap partially or fully around one or more edges of the PTC chips 14.

In some examples, the chip stops 28 may be omitted, with the PTC chips 14 retained solely by the chip tabs 26 and/or adhesive bonding. Alternatively, the chip stops 28 may be replaced with other retention features, such as raised ridges, detents, or recesses formed in the stem 24 or chip tabs 26. In some examples, the chip stops 28 may extend at angles other than perpendicular to the chip tabs 26, such as at 45-degree angles, to provide retention in multiple directions.

As shown in the cross-sectional view of FIG. 3, in some examples, each of the frame elements 12A, 12B can be substantially identical but oppositely oriented so that the chip tabs 26 of each of the frame elements 12A, 12B extend substantially parallel with one another, and in a direction that is toward one another. Furthermore, in some examples, the chip tabs 26 can be aligned so that PTC chips 14 are contacted on opposing sides (e.g., top and bottom sides) by a chip tab 26 of each of the frame elements 12A, 12B. Specifically, the PTC chips 14 can be sandwiched and cooperatively retained between the chip tabs 26 of the two frame elements 12A, 12B. As such, when PTC chips 14 are sandwiched between chip tabs 26, the chip tabs 26 can prevent up-and-down movement of the PTC chips 14 (e.g., in the Y direction), and the chip stops 28 can prevent side-to-side movement of the PTC chips 14 (e.g., in the Z direction). As shown in FIG. 3, each chip tab 26 can include a length and/or width substantially equal to a length and/or width of the PTC chip 14 to provide sufficient surface contact between the chip tab 26 and the PTC chip 14 for enhanced electrical coupling therebetween.

Furthermore, in some examples, resin, glue, a high-temperature adhesive, chemical bonding, or other bonding techniques may be applied between the PTC chips 14 and the chip tabs 26 and/or chip stops 28 to help secure the PTC chips to the bus-frame 12, thus substantially preventing movement of the PTC chips 14 in all directions (along X-, Y-, and Z-axes). For example, the PTC chips 14 may be retained by welding, soldering, brazing, or other metallurgical bonding techniques. In further examples, a combination of mechanical retention and bonding may be used, such as chip tabs 26 that mechanically retain the PTC chips 14 while a conductive adhesive provides electrical continuity. Additionally, in some examples, the electrical connection between the chip tabs 26 and the PTC chips 14 may be enhanced by conductive coatings, platings, or metallization layers applied to the PTC chips 14 and/or the chip tabs 26. In some examples, intermediate conductive elements, such as conductive pads, foils, or meshes, may be disposed between the chip tabs 26 and the PTC chips 14 to improve electrical contact.

Accordingly, in some examples, each frame element 12A, 12B may include a plurality of holding mechanisms (e.g., chip tabs 26 and chip stops 28) that can be utilized to secure the PTC chips 14 to the bus-frame 12. While the chip tabs 26 and chip stops 28 are illustrated and described herein as one example holding mechanism, other holding mechanisms may be used, including but not limited to physical features bent from or machined in the bus-frame 12 or adhesive methods, to retain the PTC chips 14 between the frame elements 12A, 12B. Spacing the holding mechanisms apart along a length of the bus-frame 12 may increase the flexibility of the bus-frame 12 and, therefore, the heating cable 10.

Additionally, in some embodiments, a tape (e.g., Kapton tape, not shown) can be wrapped around the PTC chips 14 and the chip tabs 26, once assembled, to further prevent lateral movement of the PTC chips 14 within the bus-frame 12 (e.g., along the X direction). Alternatively or additionally, in some embodiments, the PTC chips 14 and chip tabs 26 can be mechanically held in place by a crimp-like or clipping mechanism or can be bonded together with an adhesive. For example, the chip tabs 26 may include resilient fingers or spring elements that grip the PTC chips 14. Accordingly, the PTC chips 14 may be retained by interference fit, press fit, or snap fit with the chip tabs 26 and/or chip stops 28. Furthermore, in some embodiments, wrapping tension of the primary jacket 16 can further help retain the PTC chips 14 in place. Yet further, in some embodiments, the each frame element 12A, 12B may include additional placeholder tabs (not shown) spaced from one another along the frame element 12A, 12B and extending outward from the stem 24 in both the Y- and Z-directions adjacent to the chip tabs 26 and chip stops 28. The placeholder tabs can be positioned adjacent to placed PTC chips 14 to prevent movement of the PTC chips 14 in the longitudinal (X-axis) direction.

In some examples, the self-regulating heating cable 10 may be free of a solid electrically insulating receiving body in which the ceramic PTC chips 14 are embedded. That is, the PTC chips 14 may be mechanically retained by the chip tabs 26 and chip stops 28 of the bus-frame 12, rather than being embedded within or form-fittingly fixed by an insulating receiving body. The primary jacket 16 may then be wrapped around the exterior of the bus-frame 12 and PTC chips 14 assembly without lying flat against the circumferential sides of the PTC chips 14. This configuration may allow for direct contact between the chip tabs 26 and the PTC chips 14, which may reduce contact resistance and improve electrical coupling between the bus-frame 12 and the PTC chips 14.

Furthermore, in some examples, silicone or some other filler material (not shown) may be utilized to fill the space between PTC chips 14 along the length of the bus-frame 12. Reducing the presence of air in such spaces by incorporating silicon or another filler material may aid the distribution of thermal energy along the self-regulating heating cable 10, as well as to the ambient environment. The silicone may also strengthen the connection that couples the PTC chips 14 to the chip tabs 26 and therefore to the bus-frame 12.

The bus-frame 12 and the PTC chips 14 together can form an electrical pathway for current flow through the self-regulating heating cable 10. The chip tabs 26 and the chip stops 28 may comprise a conductive material (e.g., a material similar to the material of the bus-frame 12), though the chip tabs 26 may instead comprise any conductive material (e.g., metal or other conductive material). The coupling between the chip tabs 26 and the bus-frame 12 may create an electrical pathway between the bus-frame 12 and the chip tabs 26, allowing current to be conducted to and through the PTC chips 14 retained by the chip tabs 26 and chip stops 28. More specifically, placing the PTC chips 14 between respective chip tabs 26 of the bus-frame 12 can cause the PTC chip 14 to be electrically connected to the bus-frame 12 via the chip tabs 26 and chip stops 28. As a result, current may be allowed to flow through the PTC chips 14 (e.g., an electrical pathway is created from one frame element 12A/12B, through a first chip tab 26 of the frame element 12A/12B, from top to bottom of the PTC chip 14, and then through a second chip tab 26 to the other frame element 12B/12A), and the flow of current through the PTC chips 14 may generate heat by resistive conversion of electrical energy into thermal energy when voltage from a power source, such as an alternating current (AC) source (not shown), is applied to the bus-frame 12.

In some examples, the self-regulating heating cable 10 may be configured for use with an alternating current (AC) source, a direct current (DC) source, or both. The cable 10 may be compatible with various voltage levels, including low voltage (e.g., 12V, 24V, 48V), standard line voltage (e.g., 120V, 240V), or higher voltages (e.g., 277V, 480V). In some examples, the cable 10 may include or be coupled to power conditioning circuitry, such as rectifiers, transformers, or voltage regulators.

In light of the above, the PTC chips 14 can locally generate thermal energy at a plurality of locations along a length of the cable 10 that can be transferred to the ambient environment. More specifically, the thermal energy generated by the PTC chips 14 may radiate outwardly from the PTC chips 14 through the successive layers of the cable 10, including the primary jacket 16, the optional barrier layer 20, the ground plane 22, and the final jacket 18, before being transferred to the ambient environment. The inorganic materials of the primary jacket 16 and the final jacket 18 may aid the distribution and transfer of thermal energy along the length of the cable 10 and outwardly to a surface or object to be heated.

Generally, PTC chips 14 can showcase higher resistance at very low temperatures, which can benefit cold startup of the heating cable 10. More specifically, the higher initial resistance may limit inrush current when the cable 10 is first energized, reducing stress on power supply circuits and protecting associated circuitry from excessive current draw. Additionally, the higher resistance at very low temperatures may allow the PTC chips 14 to warm up gradually, reducing thermal shock and promoting more uniform heat distribution along the length of the cable 10 during startup.

Additionally, the resistance of the PTC chips 14 increases as the temperature of the PTC chips 14 is increased. As the resistance increases, the current flow through the PTC chips 14 decreases, thereby reducing the heat generated via resistive heating. The heating cable 10 is thus self-regulating in terms of the amount of thermal energy output by the cable 10, which may prevent overheating and reduce energy consumption when the cable 10 or surrounding environment reaches a target temperature. Furthermore, ceramic PTC chips 14 can allow for the cable 10 to reach the same maximum continuous exposure levels as that of conventional high temperature self-regulating cables with PFA cores. For example, in some applications, the cable 10 of some examples, incorporating the ceramic PTC core, can reach a maximum continuous exposure level of 205 degrees Celsius, or above. Furthermore, coupling the ceramic heater core with non-organic jacketing material, as described above, can allow higher intermittent exposure temperature, e.g., of up to 260 degrees Celsius, or above. For example, the cable 10, incorporating the ceramic, nonpolymeric core and inorganic jacketing, can have a higher temperature limit than the limits of conventional polymeric cables, which are based on the temperature limits of polymeric resins in use.

In light of the above, while conventional cable designs include a heater core that connects discrete conductors, such as parallel bus wires, the design of some examples does not include individual parallel conductors. Rather, the bus-frame 12 that holds the PTC chips 14 and provides structure to the cable 10 is made of a conductive material that also provides a conductive path for electrical current. By removing the separate bus conductors so that current only travels between the bus-frame 12 and the PTC chips 14, contact resistance of the cable 10 can be decreased. Additionally, the integrated bus-frame design may remove a point of potential failure in the cable assembly by eliminating the need for separate connections between discrete conductors and a lead frame.

For example, an experiment was conducted to measure linearity ratios of cables constructed using ceramic PTC chips with the same resistance range using (1) a lead frame with bus wires; and (2) the bus-frame 12 illustrated in FIGS. 1-3. It was observed that the bus-frame 12 showed an improved linearity ratio (1.269) compared to a lead frame and bus wires (1.477). Linearity ratio relates to the uniformity of electrical resistance along the cable length, and an improved (lower) linearity ratio indicates more consistent electrical performance and reduced contact resistance at the connections between the bus-frame and PTC chips. Accordingly, the design of some embodiments can decrease contact resistance, thus potentially improving electrical efficiency and performance of the cable 10.

In some applications, the separation of the PTC chips 14 from one another may aid the control of the generation and dispensation of thermal energy along the cable 10. The spacing between the PTC chips 14 can also be determined by the desired power output (defined as Watts per foot or Watts per meter) of the cable 10. In some examples, the PTC chips 14 may be separated from one another along the cable 10 by about 3 inches. However, in other examples, the PTC chips 14 may be separated by a distance that is between about 0.5 inches and about 8 inches, or between about 1 inch and about 6 inches, or between about 2 inches and about 5 inches.

Furthermore, the power output of the heating cable 10 can be varied by altering the size of the PTC chips 14, the resistance of the PTC chips 14, and/or a pitch (e.g., angle) of PTC chips 14, relative to the bus-frame 12. In one example, each PTC chip 14 may be a rectangular prism that is about 10 millimeters (mm) x about 6 mm x about 2 mm. In other examples, the PTC chips 14 may have different dimensions, such as about 8 mm x about 5 mm x about 1.5 mm, about 12 mm x about 8 mm x about 3 mm, or about 15 mm x about 10 mm x about 4 mm. In some applications, the PTC chips 14 may have a resistance between about 1 kiloohm (Kohm) and about 1.5 Kohms. In other applications, the PTC chips 14 may have a resistance between about 0.5 Kohm and about 5 Kohms, or between about 100 ohms and about 10 Kohms, depending on the desired power output and operating voltage of the cable 10. The behavior of the cable 10 can also be altered by angling the PTC chips 14 obliquely relative to the bus-frame 12. Additionally, the PTC chip 14 may be any three-dimensional shape including a cylinder, cube, triangular prism, pyramid, or other relevant 3-D shape. In one example, the cross-sectional area of the bus-frame 12 can be sized to the ampacity of the maximum desired current load of the cable 10.

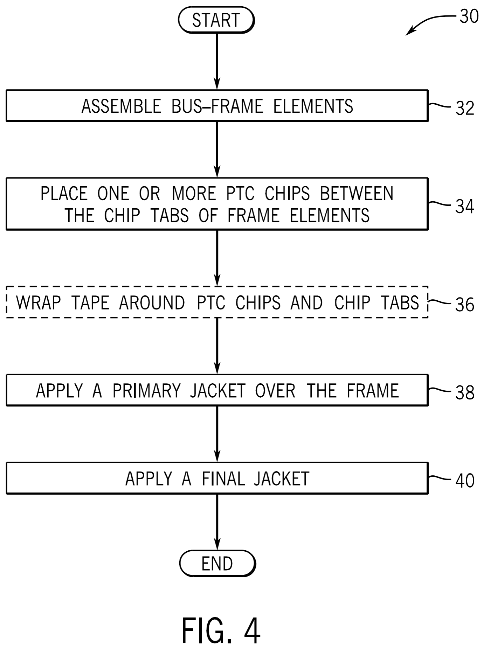

In view of the above, FIG. 4 illustrates an example method 30 for manufacturing the cable 10 of some examples. In some examples, the method 30 may be performed using an assembly line-type operation, where long lengths of the bus-frame 12 can be spooled into a reel and paid out in a continuous assembly process. Alternatively, in some examples, the method 30 may be performed using batch processing rather than continuous assembly. It should be noted that, while the method 30 in FIG. 4 is shown and described as having certain method steps in a specific order, in some implementations, the method 30 may include fewer or more steps, steps that are repeated, steps in a different order, and/or two or more steps performed simultaneously.

At step 32, the method 30 can include assembling the frame elements 12A, 12B. For example, step 32 can include unspooling and/or positioning the frame elements 12A, 12B relative to one another such that the frame elements 12A, 12B are aligned parallel to each other and spaced apart a distance approximately equivalent to a width of the PTC chips 14. In some examples, step 32 can also include crimping, stamping, bending, or otherwise mechanically forming chip tabs 26 and/or chip stops 28 of the frame elements 12A, 12B. The chip tabs 26 may be formed to extend outward from the stems 24 in a first direction (e.g., along the Z-axis), and the chip stops 28 may be formed to extend outward from the stems 24 in a second direction perpendicular to the first direction (e.g., along the Y-axis). In some examples, the chip tabs 26 and chip stops 28 may be integrally formed with the stems 24 during a stamping or punching operation. The frame elements 12A, 12B may be pre-formed with chip tabs 26 and chip stops 28 prior to assembly, or the chip tabs 26 and chip stops 28 may be formed in-line during the assembly process.

At step 34, the method 30 can include placing the PTC chips 14 between the chip tabs 26 of the bus-frame 12. At step 34, the chip tabs 26 of the bus-frame 12 may be further adjusted and aligned so that the chip tabs 26 can properly retain the PTC chips 14, with the first chip tab 26 extending over a top of the PTC chip 14 and the second chip tab 26 extending over a bottom of the PTC chip 14. In some examples, step 34 may include bending the first chip tab 26 over the PTC chip 14 and bending the second chip tab 26 over the PTC chip 14 to secure the PTC chip 14 therebetween. Additionally or alternatively, adhesives, high-temperature conductive adhesives, or chemical bonding may be applied during step 34 to couple the PTC chips 14 to the bus-frame 12. In some examples, the PTC chips 14 may be placed manually or by automated pick-and-place equipment. In some examples, steps 32 and 34 can be completed in an assembly line-type operation where the frame elements 12A, 12B are continuously fed through stations that form the chip tabs 26 and chip stops 28, place the PTC chips 14, and secure the PTC chips 14 to the bus-frame 12.

At step 36, the method 30 can optionally include applying silicone or another filler material in the spacing between PTC chips 14 along the length of the bus-frame 12. As described above, the filler material may aid the distribution of thermal energy along the self-regulating heating cable 10, as well as to the ambient environment, and may also strengthen the connection that couples the PTC chips 14 to the chip tabs 26 and therefore to the bus-frame 12. Furthermore, step 36 can optionally or additionally include wrapping the chip tabs 26 and embedded PTC chips 14 with a tape, such as Kapton tape, to further secure the PTC chips 14 within the bus-frame 12 and prevent lateral movement along the X direction.

At step 38, the method 30 can include applying a primary jacket 16 over the bus-frame 12. For example, at step 38, the primary jacket 16 can be a tape or other wrappable material that is wrapped around the bus-frame 12, such as glass tape, mica, silica, glass yarn, ceramic tape, ceramic fiber, mineral wool, or other inorganic materials. In some examples, the primary jacket 16 may be applied by wrapping the material around the first and second frame elements 12A, 12B and the PTC chips 14 in a helical or longitudinal pattern. The wrapping tension of the primary jacket 16 can further help retain the PTC chips 14 in place within the bus-frame 12. The primary jacket 16 may be applied in a separate operation or in-line with the bus-frame assembly.

At step 40, the method 30 can include applying a final jacket 18. For example, at step 40, the assembly including at least the PTC chips 14, the bus-frame 12, and the primary jacket 16 can be pulled through the final jacket 18, which may be a metallic tubing such as smooth or corrugated metallic tubing, stainless steel, or other high-temperature metal alloys. In some applications, prior to step 40, the method 30 can further include applying a barrier layer 20 (e.g., metallic foil such as aluminum foil) and/or a ground plane layer 22 (e.g., metallic braid or wrap such as tinned-copper braid) around the primary jacket 16. The method 30 concludes at an end node after the final jacket 18 has been applied. In some examples, the cable 10 may be manufactured in discrete lengths or in continuous lengths that are subsequently cut to size.

In view of the foregoing, the self-regulating heating cable of some embodiments may provide several technical benefits. The use of ceramic PTC chips suspended between conductive frame elements may allow the heating cable to be free of PFAs. The ceramic PTC chips, combined with inorganic jacket materials, may allow for higher temperature capability compared to polymeric cables, with maximum continuous exposure levels of 205 degrees Celsius or above and intermittent exposure temperatures of 260 degrees Celsius or above. The integrated bus-frame design, which amalgamates the functions of the conductor and lead frame into a single component, may provide improved linearity ratio and reduced contact resistance compared to conventional designs using separate lead frames and bus wires. Additionally, the integrated bus-frame design may eliminate a potential failure point by removing the need for separate connections between discrete conductors and a lead frame. The ceramic PTC chips may also provide cold startup benefits due to their higher resistance at very low temperatures. Furthermore, the parallel conductor construction of the bus-frame may allow the heating cable to be manufactured in long lengths and cut to length for a particular application, providing field-configurability for various uses.

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. Feature(s) of the self-regulating heating cable described may be incorporated into/used in a corresponding method or system, and vice versa.

While the structures and components disclosed herein may be embodied in many different forms, several specific examples are discussed herein with the understanding that the examples described in the present disclosure are to be considered only exemplifications of the principles described herein, and the disclosure is not intended to be limited to the examples illustrated. Throughout the disclosure, the terms "about" and "approximately" mean plus or minus 5% of the number that each term precedes, inclusive. Similarly, as used herein with respect to a reference value, the term "substantially equal" (and the like) refers to variations from the reference value of less than ± 5% (e.g., ± 2%, ± 1%, ± 0.5%) inclusive.

Unless otherwise limited or defined, "substantially parallel" indicates a direction that is within ± 12 degrees of a reference direction (e.g., within ± 6 degrees or ± 3 degrees), inclusive. Correspondingly, "substantially vertical" indicates a direction that is substantially parallel to the vertical direction, as defined relative to gravity, with a similarly derived meaning for "substantially horizontal" (relative to the horizontal direction). Likewise, unless otherwise limited or defined, "substantially perpendicular" indicates a direction that is within ± 12 degrees of perpendicular a reference direction (e.g., within ± 6 degrees or ± 3 degrees), inclusive. Likewise, unless otherwise limited or defined, "substantially radial" indicates a direction that is within ± 12 degrees of radial a reference direction (e.g., within ± 6 degrees or ± 3 degrees), inclusive. Likewise, unless otherwise limited or defined, "substantially axial" indicates a direction that is within ± 12 degrees of axial a reference direction (e.g., within ± 6 degrees or ± 3 degrees), inclusive.

Also as used herein, unless otherwise limited or defined, "substantially identical" indicates that features or components are manufactured using the same processes according to the same design and the same specifications. In some cases, substantially identical features can be geometrically congruent.

Also as used herein, unless otherwise limited or defined, "integral" and derivatives thereof (e.g., "integrally") describe elements that are manufactured as a single piece without fasteners, adhesive, or the like to secure separate components together. For example, an element stamped, cast, or otherwise molded as a single-piece component from a single piece of sheet metal or using a single mold, without rivets, screws, or adhesive to hold separately formed pieces together is an integral (and integrally formed) element. In contrast, an element formed from multiple pieces that are separately formed initially then later connected together, is not an integral (or integrally formed) element.

Unless otherwise specifically indicated, ordinal numbers are used herein for convenience of reference, based generally on the order in which particular components are presented in the relevant part of the disclosure. In this regard, for example, designations such as "first," "second," etc., generally indicate only the order in which a thus-labeled component is introduced for discussion and generally do not indicate or require a particular spatial, functional, temporal, or structural primacy or order.

It will be appreciated by those skilled in the art that while the disclosure has been described above in connection with particular examples, the disclosure is not necessarily so limited, and that numerous other examples, uses, modifications and departures from the examples are intended to be encompassed by the claims attached hereto. The entire disclosure of each patent and publication cited herein is incorporated by reference, as if each such patent or publication were individually incorporated by reference herein. Various features and advantages of the disclosure are set forth in the following claims.

## Claims

1. A self-regulating heating cable comprising:
a conductive bus-frame including a first frame element and a second frame element,
the first frame element including a first stem extending along a length of the first frame element and a first chip tab integral with and extending outward from the first stem;
the second frame element disposed parallel to the first frame element and including a second stem extending along a length of the second frame element and a second chip tab integral with and extending outward from the second stem; and
a ceramic positive temperature coefficient (PTC) chip disposed between and retained by the first chip tab and the second chip tab to create an electrical pathway from the first frame element through the first chip tab, the PTC chip, and the second chip tab to the second frame element.

2. The self-regulating heating cable of claim 1, wherein the PTC chip is further retained between the first frame element and the second frame element by a tape wrapped around the PTC chip, the first chip tab, and the second chip tab.

3. The self-regulating heating cable of claim 1 or claim 2, wherein the first frame element, the first chip tab, the second frame element, and the second chip tab comprise an electrically conductive material and provide an electrical pathway with the ceramic PTC chip.

4. The self-regulating heating cable of claim 1, claim 2 or claim 3, further comprising a primary jacket surrounding the first frame element and the second frame element.

5. The self-regulating heating cable of claim 4, wherein the primary jacket is wrapped around the first frame element and the second frame element; and/or
wherein the primary jacket comprises an inorganic material selected from glass tape, mica, silica, glass yarn, ceramic tape, ceramic fiber, or mineral wool.

6. The self-regulating heating cable of claim 4 or claim 5, further comprising a final jacket surrounding the primary jacket.

7. The self-regulating heating cable of claim 1 or of any preceding claim, wherein the first frame element is made of flat copper.

8. The self-regulating heating cable of claim 1 or of any preceding claim, wherein the first chip tab extends outward from the first stem in a first direction, and the first frame element further comprises a chip stop extending outward from the first stem in a second direction perpendicular to the first direction; and/or
wherein the first chip tab comprises a width approximately equal to a width of the PTC chip to cover a top of the PTC chip, and the second chip tab comprises the width approximately equal to the width of the PTC chip to cover a bottom of the PTC chip.

9. The self-regulating heating cable of claim 1 or of any preceding claim, wherein the PTC chip is bonded to the first chip tab and the second chip tab with a high-temperature conductive adhesive.

10. The self-regulating heating cable of claim 1 or of any preceding claim, wherein the PTC chip comprises a plurality of PTC chips spaced apart along a length of the bus-frame; and, optionally,
further comprising a filler material disposed between each of the plurality of PTC chips along the length of the bus-frame.

11. A method of producing a self-regulating heating cable, the method comprising:
aligning a first conductive frame element parallel to a second conductive frame element, wherein the first and second conductive frame elements each provide both structural support for the self-regulating heating cable and electrical conduction therethrough; and
placing a ceramic positive temperature coefficient (PTC) chip between a first chip tab of the first frame element and a second chip tab of the second frame element, such that the first chip tab extends over a top of the PTC chip and the second chip tab extends over a bottom of the PTC chip, and the PTC chip is electrically connected to the first conductive frame element via the first chip tab and to the second conductive frame element via the second chip tab.

12. The method of claim 11, further comprising applying a primary jacket over the first and second frame elements.

13. The method of claim 12, wherein applying the primary jacket includes wrapping the primary jacket around the first and second frame elements.

14. The method of claim 12 or claim 13, further comprising applying a final jacket over the primary jacket.

15. The method of claim 11 or of any of claims 12 to 14, further comprising wrapping a tape around the PTC chip, the first chip tab, and the second chip tab; and/or
further comprising bonding the PTC chip to the first chip tab and the second chip tab; and/or
wherein placing the PTC chip between the first chip tab and the second chip tab includes bending the first chip tab over the PTC chip and bending the second chip tab over the PTC chip.
